# EUROPEAN PATENT APPLICATION

(11) **EP 4 847 997 A1**
(43) Date of publication of application: **02.12.2026**
(21) Application number: 25745383.7
(22) Date of filing: 24.01.2025
(51) Int. Cl.: G03F 7/00

(54) **STAGE CALIBRATION DEVICE AND STAGE CALIBRATION METHOD USING SAME**

(30) Priority: 25.01.2024 KR 20240011665; 23.01.2025 KR 20250010720
(71) Applicant: Park Systems Corp., Yeongtong-gu Suwon-si, Gyeonggi-do 16229 (KR)
(72) Inventor: JO, Ahjin, Seoul 06204 (KR); BAIK, Seulki, Iksan-si Jeonbuk-do 54609 (KR); AHN, Byoung-Woon, Anyang-si Gyeonggi-do 14045 (KR); PARK, Sang-il, Seongnam-si Gyeonggi-do 13540 (KR)
(74) Representative: Müller Schupfner & Partner Patent- und Rechtsanwaltspartnerschaft mbB (Muc)
(86) International application number: PCT/KR2025/001447
(87) International publication number: WO 2025/159561

(57) **Abstract**

Disclosed are a stage calibration device capable of calibrating a position error of a target sample in a state in which the target sample is seated on a stage when an error in the position of the stage occurs, and a stage calibration method using the same. The stage calibration device includes a stage on which a reference sample is disposed, a scanner disposed above the stage, on which a target sample is disposed, a first measuring device that scans the reference sample to generate a first vision image including position information of the stage, a second measuring device that scans the target sample to generate a second vision image including surface information of the target sample, and a control device that controls movement of the scanner based on the position information of the stage.

## Description

### TECHNICAL FIELD

The present disclosure relates to a stage calibration device and a stage calibration method using the same, and more particularly, to a stage calibration device that positions a target sample at a target position when a unit process is performed on the target sample, and a stage calibration method using the same.

### BACKGROUND ART

In manufacturing integrated circuit devices such as semiconductor devices and display devices, a movable stage requiring high-precision specifications is used. In a state in which a target sample such as a wafer or a substrate is seated on the stage, which freely moves up, down, left, and right on an XY plane, a unit process is performed on the target sample by a working device for the unit process, or a surface of the target sample is scanned by a vision device such as a camera or a microscope, or through an atomic force microscope (AFM) or an electron microscope such as a scanning electron microscope (SEM), to generate a vision image, and the generated vision image is analyzed to derive surface information, a step, or the like of the target sample, thereby determining whether the target sample is defective.

Meanwhile, as the unit process is continuously performed in a state in which the target sample is seated on the movable stage, deformation or the like of the stage may occur due to an external environment such as temperature and humidity, or an environmental factor such as aging of the device, and as a result, an error in the position of the stage occurs, which causes the target sample to deviate from the target position. When the unit process or the like is continuously performed without correcting the error caused by the change in the position of the stage, an accurate unit process is not performed on the target sample seated on the stage, which may result in a process defect. Accordingly, in the related art, an error in the position of the stage occurring due to continuous use of the stage has been corrected through a separate alignment device or method.

However, the alignment devices or methods in the related art cannot correct the error in the position of the stage before the error in the position of the stage occurs, and when the error in the position of the stage occurs, the error in the position of the stage is corrected using a separate member such as a calibration jig.

In addition, the alignment devices or methods in the related art have had the inconvenience of having to perform calibration again whenever the position of a camera or the position of the stage is changed.

Furthermore, since the alignment or calibration operation is inconvenient and time-consuming as described above, the alignment devices or methods in the related art also have a problem in that the productivity and work efficiency of an overall product or system are lowered due to such disadvantages.

### DISCLOSURE OF INVENTION

### TECHNICAL PROBLEM

An object of the present disclosure for solving the above-described problems is to provide a stage calibration device capable of calibrating a position error of a target sample in a state in which the target sample is seated on a stage when an error in the position of the stage occurs, and a stage calibration method using the same.

Another object of the present disclosure is to provide a stage calibration device capable of calibrating a position error of a target sample without using a separate member when a position error of the stage occurs, and a stage calibration method using the same.

Still another object of the present disclosure is to provide a stage calibration device with improved productivity and work efficiency by calibrating the position of a target sample such that the target sample is positioned at a target position together with performing a unit process on the target sample, and a stage calibration method using the same.

### SOLUTION TO PROBLEM

To achieve the above-described objects, a stage calibration device according to an embodiment of the present disclosure includes: a stage on which a reference sample is disposed; a scanner disposed above the stage, on which a target sample is disposed; a first measuring device that scans the reference sample to generate a first vision image including position information of the stage; a second measuring device that scans the target sample to generate a second vision image including surface information of the target sample; and a control device that controls movement of the scanner, wherein the control device moves the scanner according to a positional variation of the stage calculated based on the position information of the stage, to position the target sample at a target position.

The first measuring device, when the second measuring device scans the target sample, scans the reference sample to acquire the position information of the stage, and the control device, when the second measuring device scans the target sample, moves the scanner to position the target sample at the target position together with acquisition of the surface information of the target sample.

The stage is provided to be movable in an X-axis direction and a Y-axis direction on an XY plane, the reference sample and the target sample move together with the stage by the same displacement as the movement of the stage, the scanner is provided to be movable in the X-axis direction and the Y-axis direction on the XY plane, above the stage, independently of the movement of the stage, and the target sample moves together with the scanner by the same displacement as the movement of the scanner.

The control device performs a second moving process of controlling the movement of the scanner to position the target sample at the target position, after performing a first moving process of controlling the movement of the stage to position the target sample at the target position.

The stage calibration device further includes a stage moving device that moves the stage and a scanner moving device that moves the scanner, wherein a displacement of the scanner moved by the scanner moving device is relatively smaller than a displacement of the stage moved by the stage moving device.

At least one marker is provided at a specific position on the reference sample, the first measuring device scans the marker to generate the first vision image including the position information of the stage, and the second measuring device scans an upper surface of the target sample to generate the second vision image including the surface information of the target sample.

The stage includes an upper frame on which the scanner is disposed, a fixed frame having a hollow into which the first measuring device is inserted, and a connecting frame connecting the upper frame and the fixed frame and providing a space in which the first measuring device scans the reference sample, wherein the target sample is disposed on the scanner, and the reference sample is disposed under the upper frame.

The reference sample includes the marker on a lower surface facing the hollow, and the first measuring device is inserted, through the hollow of the fixed frame, toward the space between the upper frame and the fixed frame provided by the connecting frame, and scans the marker included on the lower surface of the reference sample from below the reference sample.

The reference sample is embedded in the upper frame and fixedly disposed.

The stage includes an upper frame on which the scanner is disposed, a lower frame on which the reference sample is disposed, and a connecting frame connecting the upper frame and the lower frame such that at least one side of the stage is open and providing a space in which the first measuring device scans the reference sample, wherein the target sample is disposed on the scanner.

The reference sample includes the marker on an upper surface facing the upper frame, and the first measuring device is inserted, through the open side of the stage, into the space between the upper frame and the lower frame provided by the connecting frame, and scans the marker included on the upper surface of the reference sample from above the reference sample.

The reference sample is embedded in the lower frame and fixedly disposed.

To achieve the above-described objects, a stage calibration device according to an embodiment of the present disclosure includes: a stage; a scanner disposed above the stage, on which a reference sample and a target sample are disposed; a first measuring device that scans the reference sample to generate a first vision image including position information of the stage; a second measuring device that scans the target sample to generate a second vision image including surface information of the target sample; and a control device that controls movement of the scanner, wherein the control device moves the scanner according to a positional variation of the stage calculated based on the position information of the stage, to position the target sample at a target position.

To achieve the above-described objects, a stage calibration method according to an embodiment of the present disclosure includes: a stage moving step of moving a stage such that a target sample is positioned at a target position; a stage position information acquiring step of scanning, by a first measuring device, a reference sample disposed on the stage to acquire position information of the stage; a calibration step of moving a scanner provided to be movable above the stage, based on the position information of the stage, such that the target sample disposed on the scanner is positioned at the target position; and a sample shape acquiring step of scanning, by a second measuring device, the target sample positioned at the target position.

After the sample shape acquiring step of scanning, by the second measuring device, the target sample positioned at the target position, the method further includes: a second stage position information acquiring step of rescanning, by the first measuring device, the reference sample disposed on the stage to acquire the position information of the stage; a second calibration step of moving the scanner a second time, based on the position information of the stage acquired by the first measuring device rescanning the reference sample, such that the target sample disposed on the scanner is positioned at the target position; and a second sample shape acquiring step of rescanning, by the second measuring device, the target sample positioned at the target position.

### ADVANTAGEOUS EFFECTS OF INVENTION

According to the stage calibration device and the stage calibration method using the same of the present disclosure, when an error in the position of the stage occurs, a position error of a target sample can be calibrated in a state in which the target sample is seated on a stage.

According to the stage calibration device and the stage calibration method using the same of the present disclosure, when a position error of the stage occurs, a position error of a target sample can be calibrated without using a separate member.

According to the stage calibration device and the stage calibration method using the same of the present disclosure, productivity and work efficiency are improved by calibrating the position of a target sample such that the target sample is positioned at a target position together with performing a unit process on the target sample.

### BRIEF DESCRIPTION OF DRAWINGS

FIG. 1 is a view schematically showing a stage calibration device according to an embodiment of the present disclosure.
FIG. 2 schematically illustrates a control device according to the present disclosure moving a scanner based on position information of a stage.
FIG. 3 is a view showing a stage according to an embodiment of the present disclosure.
FIG. 4 is a view schematically showing a stage calibration device according to another embodiment of the present disclosure.
FIG. 5 is a view schematically showing a stage calibration device according to still another embodiment of the present disclosure.
FIG. 6 is a view showing a plurality of markers arranged on a reference sample according to the present disclosure.
FIGS. 7 to 10 are flowcharts of a stage calibration method according to the present disclosure.

### BEST MODE FOR CARRYING OUT THE INVENTION

Hereinafter, some embodiments of the present disclosure will be described in detail with reference to exemplary drawings. In adding reference numerals to components of each drawing, it should be noted that like components are denoted by like reference numerals wherever possible, even if they are shown in different drawings.

In addition, in describing the embodiments of the present disclosure, when it is determined that a detailed description of a related known configuration or function may obscure understanding of the embodiments of the present disclosure, the detailed description thereof will be omitted.

In addition, in describing the components of the embodiments of the present disclosure, terms such as first, second, A, B, (a), and (b) may be used. These terms are only for distinguishing the components from other components, and the nature, order, or sequence of the corresponding components is not limited by the terms.

In this specification, the singular form includes the plural form unless specifically stated otherwise in the phrase. As used in the specification, 'comprises' and/or 'comprising' does not exclude the presence or addition of one or more other components in addition to the stated components.

Hereinafter, the present disclosure will be described in more detail with reference to the accompanying drawings.

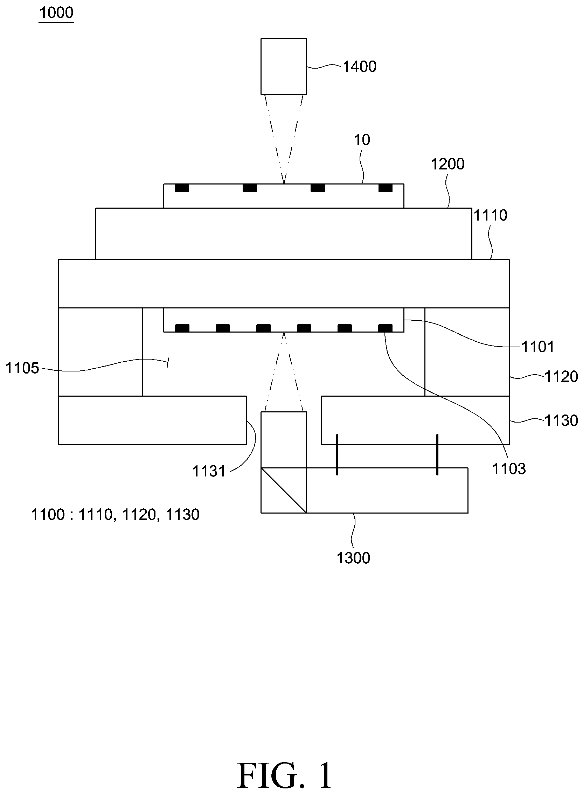

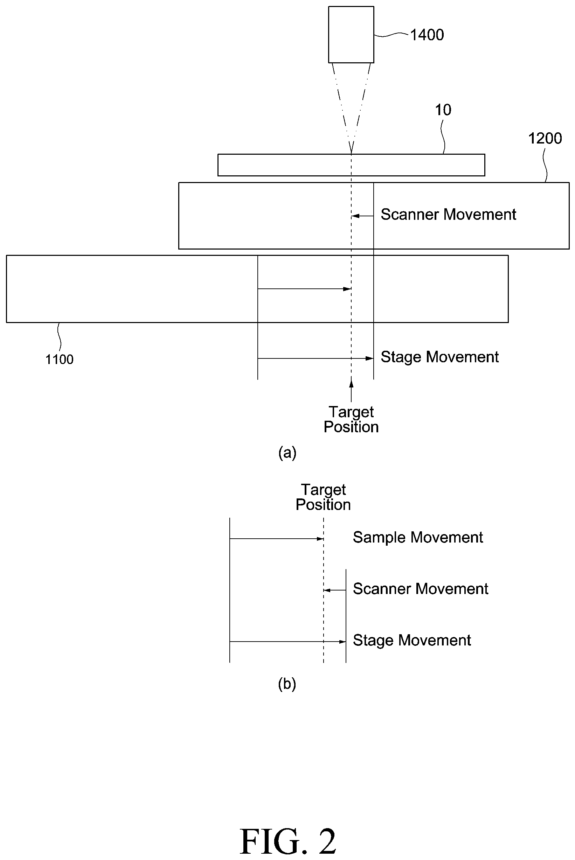

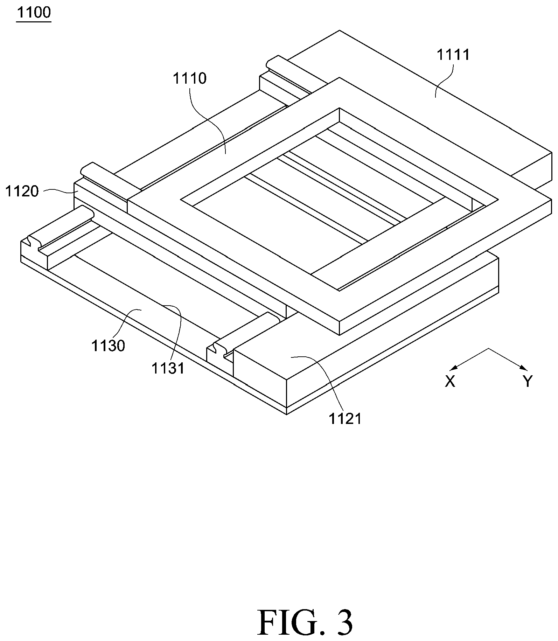

FIG. 1 is a view schematically showing a stage calibration device 1000 according to an embodiment of the present disclosure, FIG. 2 schematically illustrates a control device according to the present disclosure moving a scanner 1200 based on position information of a stage 1100, and FIG. 3 is a view showing the stage 1100 according to an embodiment of the present disclosure.

Referring to FIGS. 1 to 3, the stage calibration device 1000 according to an embodiment of the present disclosure includes the stage 1100, the scanner 1200, a first measuring device 1300, and a second measuring device 1400.

The stage calibration device 1000 further includes a reference sample 1101 disposed on the stage 1100. The reference sample 1101 is for acquiring position information of the stage 1100, and a plurality of markers 1103 are disposed thereon, and the markers 1103 are captured by the first measuring device 1300.

Although not shown in the drawings, the stage calibration device 1000 further includes a control device (not shown) that controls movement of the stage 1100 and the scanner 1200, and a computation device (not shown) that calculates a position of the stage 1100 and a positional variation thereof.

The reference sample 1101 is disposed on the stage 1100. More specifically, the reference sample 1101 is disposed on an upper frame 1110 of the stage 1100. In detail, the reference sample 1101 may be disposed to be inverted on a lower surface of the upper frame 1110. A detailed description of the upper frame 1110 will be given later.

A target sample 10 on which a unit operation is performed is disposed above the stage 1100. More specifically, the scanner 1200 is provided above the stage 1100, and the target sample 10 is disposed on the scanner 1200. The target sample 10 includes a wafer, a substrate, or the like.

The first measuring device 1300 scans the reference sample 1101 disposed on the stage 1100 to generate a first vision image. The first vision image includes the plurality of markers 1103 including the position information of the stage 1100. The first vision image generated by the first measuring device 1300 is processed by the computation device to derive the position information of the stage 1100.

The computation device derives the position information of the stage 1100 based on the plurality of markers 1103 included in the first vision image. The computation device calculates the positional variation of the stage 1100 based on the derived position information of the stage 1100. The computation device calculates the positional variation of the stage 1100 by comparing the first vision image generated by the first measuring device with a previously stored or previously generated first vision image.

The control device controls the movement of the scanner 1200 according to the positional variation of the stage 1100 calculated based on the position information of the stage 1100. The control device controls the movement of the scanner 1200 to position the target sample 10 disposed on the scanner 1200 at a target position.

The second measuring device 1400 scans the target sample 10 disposed on the scanner 1200 to generate a second vision image. The second measuring device 1400 scans the target sample 10 positioned at the target position to generate the second vision image. The second vision image includes surface information of the target sample 10. The computation device derives surface information, such as a surface roughness and a surface step of the target sample 10, based on the surface information of the target sample 10 included in the second vision image. Whether the target sample 10 is defective, or the like, can be derived through the surface information of the target sample 10 derived by the computation device analyzing the second vision image.

The first measuring device 1300 scans a surface of the reference sample 1101 to generate the first vision image, when the second measuring device 1400 scans the target sample 10 to generate the second vision image or before or after the generation of the second vision image (hereinafter referred to as 'performing a unit process by the second measuring device 1400'). The first vision image generated by the first measuring device 1300 is processed by the computation device to acquire the position information of the stage 1100. The first measuring device 1300 scans the reference sample 1101 together with performing the unit process in which the second measuring device 1400 scans the target sample 10, to acquire the position information of the stage 1100.

When the positional variation of the stage 1100 occurs based on the position information of the stage 1100 during the performing of the unit process by the second measuring device 1400, the control device moves the scanner 1200 to position the target sample 10 at the target position. As the control device moves the scanner 1200 based on the position information of the stage 1100 acquired by the first measuring device 1300 together with the acquisition of the surface information of the target sample 10 by the second measuring device 1400, the position of the target sample 10 can be calibrated together with performing the unit process on the target sample 10.

Hereinafter, the stage calibration device 1000 according to the present disclosure will be described in more detail.

The stage 1100 is provided to be freely movable in an X-axis and a Y-axis on an XY plane. More specifically, the scanner 1200 is disposed on the upper frame 1110 of the stage 1100, and the upper frame 1110 is provided to be freely movable in the X-axis and the Y-axis on the XY plane.

The position of the scanner 1200 is changed according to the movement of the stage 1100, more specifically, the upper frame 1110. Alternatively, as the unit process is continuously performed in a state in which the target sample 10 is disposed on the stage 1100, the stage 1100 moves due to an environmental factor such as an external environment or aging of the device, so that the positions of the stage 1100 and the scanner 1200 are changed. According to the change in the position of the stage 1100, the position of the target sample 10 together with the scanner 1200 is changed.

According to the movement of the stage 1100, the positions of the reference sample 1101 and the target sample 10 are changed together with the stage 1100. The reference sample 1101 and the target sample 10 move together with the stage 1100 by the same displacement as the movement of the stage 1100.

The scanner 1200 is provided to be freely movable in the X-axis and the Y-axis on the XY plane. The scanner 1200 is provided to be movable in the X-axis and the Y-axis above the stage 1100, independently of the movement of the stage 1100.

According to the movement of the scanner 1200, the target sample 10 also moves together. The target sample 10 moves together with the scanner 1200 by the same displacement as the movement of the scanner 1200.

The stage 1100 changes the position of the target sample 10 such that the target sample 10 is positioned at the target position according to the X-axis and Y-axis movement. The stage 1100 is movable in the X-axis and the Y-axis by stage moving devices 1111 and 1121 driven according to a control signal of the control device. The stage moving devices 1111 and 1121 include a stage X-axis moving device 1121 and a stage Y-axis moving device 1111 driven according to the control signal of the control device. The stage 1100 is movable in the X-axis and the Y-axis by driving of the stage X-axis moving device 1121 and the stage Y-axis moving device 1111, respectively.

The scanner 1200 is installed above the stage 1100. The target sample 10 is disposed on the scanner 1200. The target sample 10 may be a sample for performing a unit process. According to the X-axis movement and the Y-axis movement of the stage 1100, the scanner 1200 and the target sample 10 also move in the X-axis and the Y-axis together. According to the movement of the scanner 1200 and the target sample 10 by the movement of the stage 1100, the target sample 10 can be positioned at the target position.

A unit process performing device that performs a unit process on the target sample 10 is disposed above the target sample 10. According to an embodiment, the second measuring device 1400 that captures the target sample 10 is disposed above the target sample 10. The second measuring device 1400 scans and/or captures the target sample 10 positioned at the target position to generate the second vision image including surface information such as a surface roughness and a step of the target sample 10. The second vision image captured and acquired by the second measuring device 1400 may be analyzed through a separate computation device (not shown) to acquire the surface information of the target sample 10.

The reference sample 1101 is disposed inside the stage 1100. In detail, the reference sample 1101 is disposed below the upper frame 1110. According to the X-axis movement and the Y-axis movement of the stage 1100, in detail, the upper frame 1110, the reference sample 1101 also moves in the X-axis and the Y-axis together. The position of the reference sample 1101 is changed according to the movement and positional variation of the stage 1100 caused by the stage moving devices 1111 and 1121 and/or an environmental factor.

The plurality of markers 1103 are formed on at least one surface of the reference sample 1101. As an embodiment, the reference sample 1101 is inverted and fixedly disposed on a lower surface of the stage 1100, in detail, the upper frame 1110. When the reference sample 1101 is inverted and fixedly disposed on the lower surface of the stage 1100, the plurality of markers 1103 are arranged on a lower surface of the reference sample 1101.

The first measuring device 1300 that captures the reference sample 1101 is disposed below the stage 1100. The first measuring device 1300 captures the reference sample 1101 to acquire the position information of the stage 1100. The first measuring device 1300 captures the markers 1103 arranged on the reference sample 1101 to acquire the position information of the stage 1100. The first measuring device 1300 captures at least one surface of the reference sample 1101 to generate the first vision image including the at least one surface of the reference sample 1101. The first vision image generated by the first measuring device 1300 includes the markers 1103 arranged on the reference sample 1101. The first vision image generated by the first measuring device 1300 includes a specific marker 1103 among the plurality of markers 1103 representing the position information of the stage 1100. The computation device analyzes the vision image generated by the first measuring device 1300 to derive the position information of the stage 1100. The computation device analyzes a type and/or a position of the marker 1103 included in the vision image generated by the first measuring device 1300 to derive the position information of the reference sample 1101 and the stage 1100.

The control device moves the scanner 1200 based on the position information of the stage 1100 acquired by the first measuring device 1300, in detail, the position information of the stage 1100 derived by the computation device.

The scanner 1200 is provided to be independently movable separately from the movement of the stage 1100. The scanner 1200 is provided above the stage 1100 to be freely movable in the X-axis and the Y-axis on the XY plane. The scanner 1200 is independently movable on the stage 1100 by a scanner moving device (not shown) provided separately from the stage moving devices 1111 and 1121 that freely move the stage 1100 on the XY plane. The scanner moving device includes a scanner X-axis moving device (not shown) and a scanner Y-axis moving device (not shown) that move the scanner 1200 in the X-axis and the Y-axis, respectively.

The scanner 1200 is independently movable on the stage 1100 by the scanner X-axis moving device and the scanner Y-axis moving device provided separately from the stage X-axis moving device 1121 and the stage Y-axis moving device 1111 that move the stage 1100 in the X-axis and the Y-axis. The stage moving devices 1111 and 1121 and the scanner moving device include known motors, rails, and the like capable of moving the stage 1100 and the scanner 1200, respectively. The same motor, rail, and the like as those of the stage moving devices 1111 and 1121 may be applied to the scanner moving device.

The control device drives the scanner X-axis moving device and the scanner Y-axis moving device to move the scanner 1200 such that the target sample 10 is positioned at the target position. The control device changes the position of the target sample 10 through the movement of the scanner 1200.

When a position error of the stage 1100 occurs due to an environmental factor or the like, the control device may position the target sample 10 at the target position by controlling the movement of the scanner 1200 through the scanner moving device based on the position error of the stage 1100.

The control device may perform a second moving process of controlling the movement of the scanner 1200 through the scanner moving device to position the target sample 10 at the target position, after performing a first moving process of controlling the movement of the stage 1100 through the stage moving devices 1111 and 1121 to position the target sample 10 at the target position.

A movement displacement of the scanner 1200 moved by the scanner moving device may be relatively smaller than a displacement of the stage 1100 moved by the stage moving devices 1111 and 1121.

Referring to FIG. 2, the control device moves the scanner 1200 such that the target sample 10 seated on the scanner 1200 is positioned at the target position. The control device moves the scanner 1200 by driving the scanner X-axis moving device and the scanner Y-axis moving device, respectively, based on the position information of the stage 1100.

The computation device compares, based on first position information of the stage 1100 in a state in which the target sample 10 is positioned at the target position, the first position information with second position information of the current stage 1100, and derives a difference between the first position information and the second position information as position error information of the stage 1100. The control device moves the scanner 1200 in an opposite direction by a position error corresponding to the difference between the first position information and the second position information derived by the computation device, to change the position of the target sample 10 such that the target sample 10 is positioned at the target position. For example, when the error information derived by the computation device is +1 mm in the X-axis direction, the control device moves the scanner 1200 by -1 mm in the X-axis direction.

The stage 1100 and the scanner 1200 are freely movable in the X-axis and the Y-axis by the stage moving devices 1111 and 1121 and the scanner moving device, respectively. As described above, the movement of the scanner 1200 by the scanner moving device enables a finer movement than the movement of the stage 1100 by the stage moving devices 1111 and 1121.

According to the movement of the stage 1100, the scanner 1200 and the target sample 10 move together, so that the target sample 10 is positioned at the target position. Since the entire stage 1100 and scanner 1200 move together, it is difficult for the movement of the stage 1100 to accurately position the target sample 10 at the target position. On the other hand, since only the scanner 1200 disposed on an upper end of the stage 1100 moves in the movement of the scanner 1200, it is easier to accurately position the target sample 10 at the target position than by the movement of the stage 1100.

Therefore, after a first moving process of moving the stage 1100 such that the target sample 10 is positioned at the target position, a position error caused by the movement of the stage 1100 is calculated, and based on the calculated position error, the scanner 1200 is moved through a second moving process, so that the target sample 10 can be more easily positioned at the target position to be calibrated.

In addition, when a position error of the stage 1100 caused by an environmental factor such as an external environment, aging of the device, or vibration occurs during the unit process of the target sample 10, the scanner 1200 is moved based on the position error of the stage 1100, so that the target sample 10 can be calibrated to be positioned at the target position during the unit process of the target sample 10.

When the second measuring device 1400 captures the target sample 10 to acquire the surface information of the target sample 10, the first measuring device 1300 simultaneously captures the reference sample 1101 to acquire the position information of the stage 1100, and the control device moves the scanner 1200 based on the acquired position information of the stage 1100.

In detail, the first measuring device 1300 captures the reference sample 1101 during the performing of the unit process by the second measuring device 1400, the computation device derives the position information of the stage 1100 through analysis of the vision image captured by the first measuring device 1300, and the control device moves the scanner 1200 based on the position information of the stage 1100. Therefore, while the second measuring device 1400 performs a unit operation on the target sample 10, the position of the target sample 10 can be calibrated together with acquisition of the surface information of the target sample 10 according to the movement of the scanner 1200.

The computation device derives, based on second position information of the stage 1100 when the target sample 10 is positioned at the target position according to the movement of the scanner 1200, a difference between the second position information and position information of the stage 1100 acquired by the first measuring device 1300 recapturing the reference sample 1101, as a new position error of the stage 1100, and moves the scanner 1200 in an opposite direction by the newly derived position error, so that the position of the target sample 10 can be calibrated again during the unit process of the target sample 10.

At least one marker 1103 is provided at a specific position on the reference sample 1101, and the first measuring device 1300 scans the marker 1103 provided on the reference sample 1101 to acquire the position information of the stage 1100. The reference sample 1101 may be embedded in the stage 1100 and fixedly disposed. As the reference sample 1101 is embedded in the stage 1100, the movement and positional variation of the reference sample 1101 may occur integrally with the movement and positional variation of the stage 1100. As the target sample 10 is seated on an upper side of the scanner 1200 disposed on the stage 1100, the reference sample 1101 and the target sample 10 move together unless the scanner 1200 moves independently.

The target sample 10 is disposed on the scanner 1200, and the reference sample 1101 is disposed under the stage 1100, so that the target sample 10 and the reference sample 1101 move together by the movement of the stage 1100. The second measuring device 1400 is disposed above the scanner 1200 and the target sample 10 to scan an upper surface of the target sample 10. The first measuring device 1300 is disposed below the reference sample 1101, and captures the marker 1103 of the reference sample 1101 to acquire the position information of the stage 1100.

The stage 1100 according to an embodiment of the present disclosure includes the upper frame 1110, a connecting frame 1120, and a fixed frame 1130.

The scanner 1200 is disposed on the upper frame 1110 according to an embodiment of the present disclosure, and the reference sample 1101 is disposed under the upper frame 1110. The target sample 10 and the second measuring device 1400 installed toward the target sample 10 are disposed on the scanner 1200.

The target sample 10 is disposed on the stage 1100, and the reference sample 1101 is disposed inside the stage 1100. The target sample 10 and the reference sample 1101 move integrally with the upper frame 1110 according to the movement of the stage 1100, more specifically, according to the movement of the upper frame 1110.

The fixed frame 1130 according to an embodiment of the present disclosure may be fixedly installed on the ground or a separate device. The fixed frame 1130 has a hollow 1131 open to an inside and an outside. At least a part of the first measuring device 1300 is inserted into the hollow 1131 of the fixed frame 1130. At least a part of the first measuring device 1300 may be fixed to the fixed frame 1130.

The connecting frame 1120 according to an embodiment of the present disclosure connects the upper frame 1110 and the fixed frame 1130, and provides a space 1105 in which the first measuring device 1300 can scan and/or capture at least one surface of the reference sample 1101. Through the space 1105 provided by the connecting frame 1120, the first measuring device 1300 scans and/or captures the marker 1103 of the reference sample 1101.

The reference sample 1101 according to an embodiment of the present disclosure may be embedded in the upper frame 1110 and fixedly disposed. The reference sample 1101 is inverted and fixedly disposed such that one surface on which the plurality of markers 1103 are arranged faces the hollow 1131 of the fixed frame 1130. The plurality of markers 1103 of the reference sample 1101 are arranged along a lower surface of the reference sample 1101. The first measuring device 1300 is inserted, through the hollow 1131 of the fixed frame 1130, toward the space 1105 provided by the connecting frame 1120, and scans and/or captures the marker 1103 included on the lower surface of the reference sample 1101 from below the reference sample 1101.

Referring to FIG. 3, the stage 1100 according to an embodiment of the present disclosure may be an XY stage 1100 having a shape in which central portions of the fixed frame 1130 and the upper frame 1110 are open. The first measuring device 1300 is inserted through the open hollow 1131 of the fixed frame 1130, and can capture the lower surface of the reference sample 1101 inverted and fixedly disposed on the lower surface of the upper frame 1110, in the space 1105 between the fixed frame 1130 and the upper frame 1110.

The connection between the connecting frame 1120 and the fixed frame 1130 may be by a rail. By driving of the stage X-axis moving device 1121, the connecting frame 1120 can move in the X-axis direction on the fixed frame 1130 through the rail. When the connecting frame 1120 moves in the X-axis direction on the fixed frame 1130 by the driving of the stage X-axis moving device 1121, the upper frame 1110 can move in the X-axis direction together with the connecting frame 1120.

The connection between the connecting frame 1120 and the upper frame 1110 may be by a rail. By driving of the stage Y-axis moving device 1111, the upper frame 1110 can move in the Y-axis direction on the connecting frame 1120 through the rail.

The upper frame 1110 can freely move in the X-axis and the Y-axis on the XY plane by the driving of the stage X-axis moving device 1121 and the stage Y-axis moving device 1111. By the movement of the upper frame 1110, the reference sample 1101 and the target sample 10 directly or indirectly disposed on the upper frame 1110 can also freely move in the X-axis and the Y-axis together with the upper frame 1110. The plurality of markers 1103 are arranged on the lower surface of the reference sample 1101 facing the hollow 1131, and the first measuring device 1300, in a state of being fixed to be inserted, through the hollow 1131 of the fixed frame 1130, toward the space 1105 between the upper frame 1110 and the fixed frame 1130 provided by the connecting frame 1120, captures the marker 1103 arranged on the lower surface of the reference sample 1101, thereby acquiring position information of the stage 1100, more specifically, the upper frame 1110.

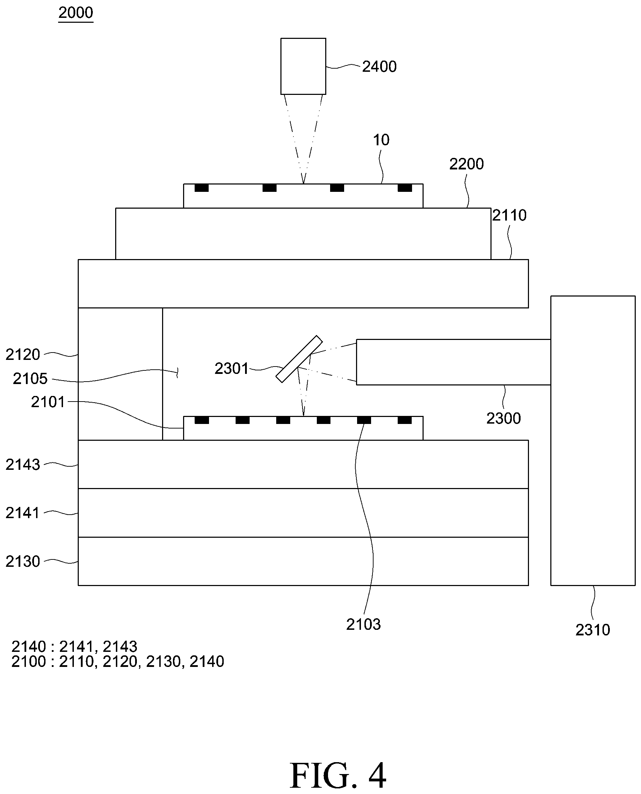

FIG. 4 is a view schematically showing a stage calibration device 2000 according to another embodiment of the present disclosure.

Referring to FIG. 4, the stage calibration device 2000 according to another embodiment of the present disclosure includes a stage 2100, a scanner 2200, a first measuring device 2300, and a second measuring device 2400.

The stage 2100 according to another embodiment of the present disclosure includes an upper frame 2110, a lower frame 2140, a connecting frame 2120, and a fixed frame 2130.

The scanner 2200 is disposed on the upper frame 2110 according to another embodiment of the present disclosure, and a reference sample 2101 is disposed on the lower frame 2140. The reference sample 2101 is disposed in a forward direction such that a plurality of markers 2103 are arranged on an upper surface facing the upper frame 2110. The reference sample 2101 may be embedded in the lower frame 2140 and fixedly disposed.

The connecting frame 2120 according to another embodiment of the present disclosure connects the upper frame 2110 and the lower frame 2140. The connecting frame 2120 is provided such that at least one side of the stage 2100 is open when connecting the upper frame 2110 and the lower frame 2140. The first measuring device 2300 that scans and/or captures the marker 2103 of the reference sample 2101 is inserted through the open one side of the connecting frame 2120. The first measuring device 2300 may be fixedly disposed through a fixing portion 2310 fixedly installed on the ground or a separate device. The connecting frame 2120 provides a space 2105 in which the first measuring device 2300 scans and/or captures the reference sample 2101 between the upper frame 2110 and the lower frame 2140.

The first measuring device 2300 according to another embodiment of the present disclosure is inserted, through the open one side of the stage 2100, into the space 2105 between the upper frame 2110 and the lower frame 2140 provided by the connecting frame 2120, and scans and/or captures the plurality of markers 2103 arranged on the upper surface of the reference sample 2101.

Unlike the stage 1100 according to the above-described embodiment of the present disclosure, in the stage 2100 according to another embodiment of the present disclosure, the plurality of markers 2103 of the reference sample 2101 are arranged on the upper surface of the reference sample 2101, and the first measuring device 2300 that scans and/or captures the marker 2103 of the reference sample 2101 is inserted into the inside of the stage 2100 through an opening provided on one side surface of the stage 2100, and then scans and/or captures the upper surface of the reference sample 2101.

In another embodiment of the present disclosure, as the first measuring device 2300 is inserted into the internal space 2105 of the stage 2100 through the open one side of the stage 2100, there is a feature that the stability of the stage 2100 can be ensured because it is unnecessary to form the hollow 1131 in the fixed frame 1130 as in the above-described embodiment of the present disclosure.

The lower frame 2140 according to another embodiment of the present disclosure may include a first lower frame 2141 and a second lower frame 2143. The first lower frame 2141 and the second lower frame 2143 may be installed to be movable in directions crossing each other on the XY plane.

The stage 2100 according to another embodiment of the present disclosure may further include a fixed frame 2130 fixedly installed on the ground or a separate device. The first lower frame 2141 may be connected and installed on an upper surface of the fixed frame 2130 through a rail.

The first lower frame 2141 can move in the X-axis direction along a rail on the upper surface of the fixed frame 2130 according to driving of a stage X-axis moving device (not shown). According to the X-axis direction movement of the first lower frame 2141, the second lower frame 2143, the connecting frame 2120, the upper frame 2110, and the scanner 2200 connected to the first lower frame 2141 can move together in the X-axis direction. As the first lower frame 2141, the second lower frame 2143, the connecting frame 2120, the upper frame 2110, and the scanner 2200 move together in the X-axis direction by the X-axis direction movement of the first lower frame 2141, the reference sample 2101 and the target sample 10 can move together in the X-axis direction.

The second lower frame 2143 may be connected and installed on an upper portion of the first lower frame 2141 through a rail. The second lower frame 2143 can move in the Y-axis direction along a rail on the upper surface of the first lower frame 2141 according to driving of a stage Y-axis moving device (not shown). According to the Y-axis direction movement of the second lower frame 2143, the connecting frame 2120, the upper frame 2110, and the scanner 2200 connected to the second lower frame 2143 can move together in the Y-axis direction. As the second lower frame 2143, the connecting frame 2120, the upper frame 2110, and the scanner 2200 move together in the Y-axis direction by the Y-axis direction movement of the second lower frame 2143, the target sample 10 and the reference sample 2101 can move together in the Y-axis direction. The first measuring device 2300 scans and/or captures the reference sample 2101 to generate a first vision image, the computation device analyzes the first vision image, and the control device moves the scanner 2200 independently of the stage 2100 to position the target sample 10 at a target position. The first measuring device 2300 may further include a separate lens 2301 that changes a traveling direction of a light source for scanning and/or capturing the reference sample 2101.

The stage calibration device 2000 shown in FIG. 4 and the stage calibration device 1000 described with reference to FIGS. 1 to 3 include components that are equally applied to each other, and therefore, descriptions of the equally applied components are omitted or briefly described. For example, the scanner 2200 and the second measuring device 2400 may be equally applied as the scanner 1200 and the second measuring device 1400 described with reference to FIGS. 1 to 3.

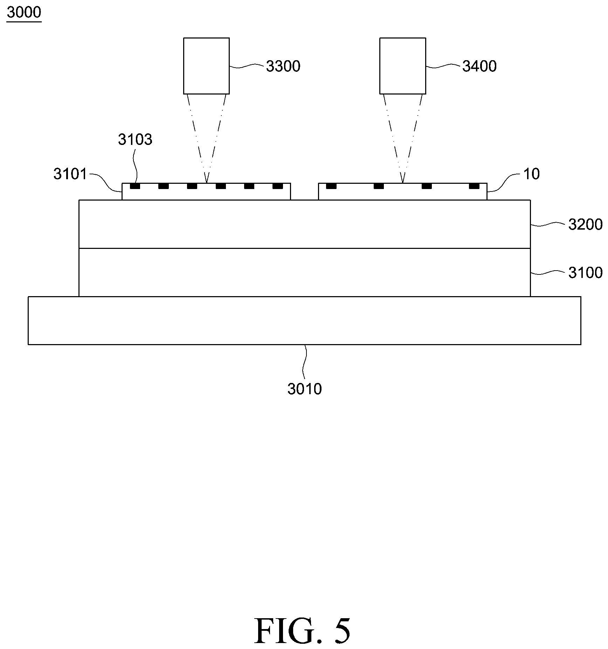

FIG. 5 is a view schematically showing a stage calibration device 300 according to still another embodiment of the present disclosure.

Referring to FIG. 5, the stage calibration device 3000 according to still another embodiment of the present disclosure includes a base 3010, a stage 3100, a scanner 3200, a first measuring device 3300, and a second measuring device 3400.

The stage 3100 is disposed above the base 3010. The stage 3100 is provided to be freely movable in the X-axis and the Y-axis on the XY plane, like the above-described stage 1100.

The scanner 3200 is provided above the stage 3100, and a reference sample 3101 and the target sample 10 are disposed thereon. The scanner 3200 is provided to be freely movable in the X-axis and the Y-axis on the XY plane, like the above-described scanner 1200.

The reference sample 3101 is for acquiring position information of the stage 3100, like the above-described reference samples 1101 and 2101, and a plurality of markers 3103 are disposed thereon, and the markers 3103 are captured by the first measuring device 3300.

The first measuring device 3300, like the above-described first measuring device 1300, scans the reference sample 3101 to generate a first vision image including position information of the stage 3100. The first vision image generated by the first measuring device 3300 is processed by the above-described computation device to derive the position information of the stage 3100.

The second measuring device 3400, like the above-described second measuring device 1400, scans the target sample 10 to generate a second vision image including surface information of the target sample 10. As described above, the computation device derives surface information, such as a surface roughness and a surface step of the target sample 10, based on the surface information of the target sample 10 included in the second vision image. Whether the target sample 10 is defective, or the like, can be derived through the surface information of the target sample 10 derived by the computation device analyzing the second vision image.

The first measuring device 3300 and the second measuring device 3400 are fixed by a support structure (not shown) connected from the base 3010, and can acquire the surface information of the reference sample 3101 and the target sample 10, respectively, from above the scanner 3200.

Although not shown in the drawings, the stage calibration device 3000 includes a control device that controls movement of the stage and the scanner. As described above, the control device can move the scanner 3200 according to a positional variation of the stage 3100 calculated based on the position information of the stage 3100, to position the target sample 10 at a target position.

The stage calibration device 3000 shown in FIG. 5 and the stage calibration device 1000 described with reference to FIGS. 1 to 3 include components that are equally applied to each other, and therefore, descriptions of the equally applied components are omitted or briefly described. For example, the stage 3100, the scanner 3200, the first measuring device 3300, the second measuring device 3400, the control device, and the computation device may respectively have the same or equivalent configurations as the stage 1100, the scanner 1200, the first measuring device 1300, the second measuring device 1400, the control device, and the computation device described with reference to FIGS. 1 to 3.

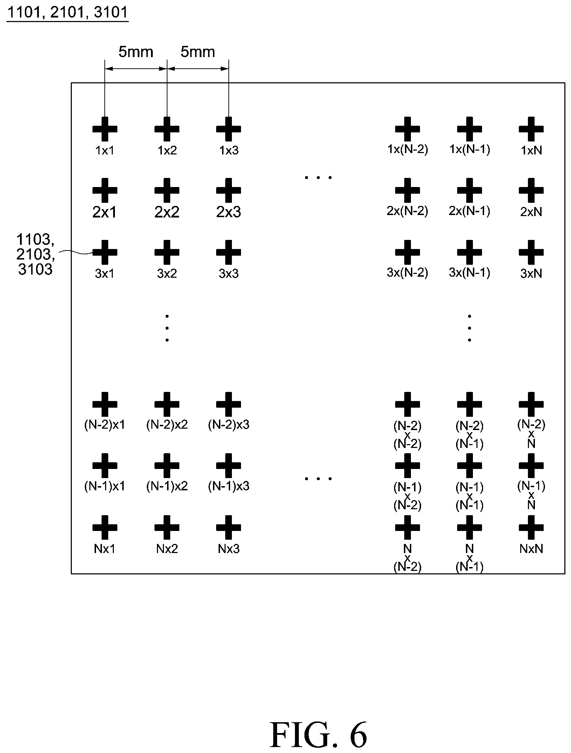

FIG. 6 is a view showing the plurality of markers 1103, 2103, and 3103 arranged on the reference samples 1101, 2101, and 3101 according to the present disclosure.

Referring to FIG. 6, the plurality of markers 1103, 2103, and 3103 are arranged on at least one surface of the reference samples 1101, 2101, and 3101. Address information indicating the position of the marker 1103, 2103, or 3103 may be arranged together below each marker 1103, 2103, or 3103. The address information of a specific marker 1103, 2103, or 3103 is included together with the specific marker among the plurality of markers 1103, 2103, and 3103 in the first vision image captured by the first measuring device 1300, 2300, or 3300, and the computation device analyzes the first vision image to derive the address information of the corresponding marker 1103, 2103, or 3103, and can derive position information of the stage 1100, 2100, or 3100, more specifically, the upper frame 1110 or 2110, through position information at which the marker 1103, 2103, or 3103 is located in the first vision image. Each of the markers 1103, 2103, and 3103 may be arranged, for example, at intervals of 5 mm, and horizontal arrangement information and vertical arrangement information may be arranged together at a lower end portion of each marker 1103, 2103, or 3103.

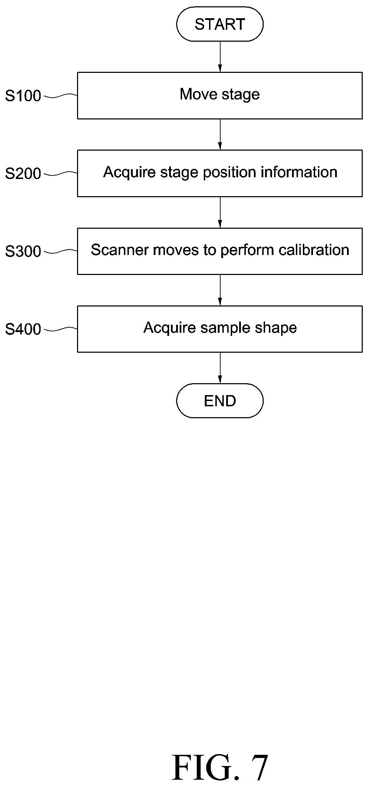

FIGS. 7 to 10 are flowcharts of the stage calibration method according to the present disclosure.

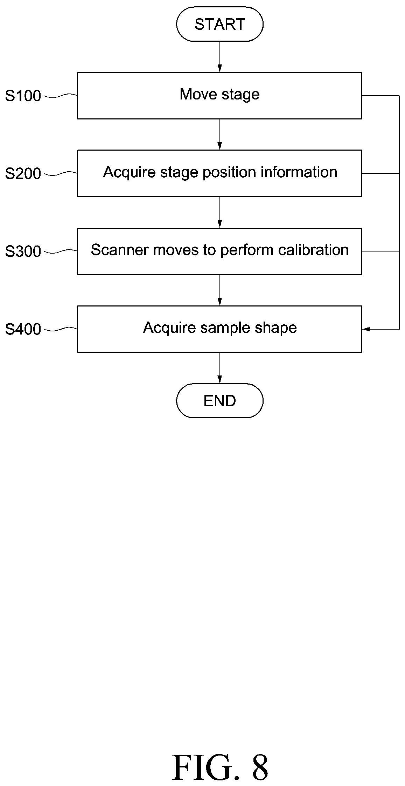

Referring to FIGS. 7 and 8, the stage calibration method according to the present disclosure includes: a stage moving step (S100) in which the stage 1100, 2100, or 3100 moves such that the target sample 10 is positioned at the target position; a stage position information acquiring step (S200) in which the first measuring device 1300, 2300, or 3300 scans and/or captures the reference sample 1101, 2101, or 3101 disposed on the stage 1100, 2100, or 3100 to acquire position information of the stage 1100, 2100, or 3100; a calibration step (S300) in which the scanner 1200, 2200, or 3200 provided to be movable above the stage 1100, 2100, or 3100 moves based on the position information of the stage 1100, 2100, or 3100 such that the target sample 10 disposed on the scanner 1200, 2200, or 3200 is positioned at the target position; and a sample shape acquiring step (S400) in which the second measuring device 1400, 2400, or 3400 scans and/or captures the target sample 10 positioned at the target position.

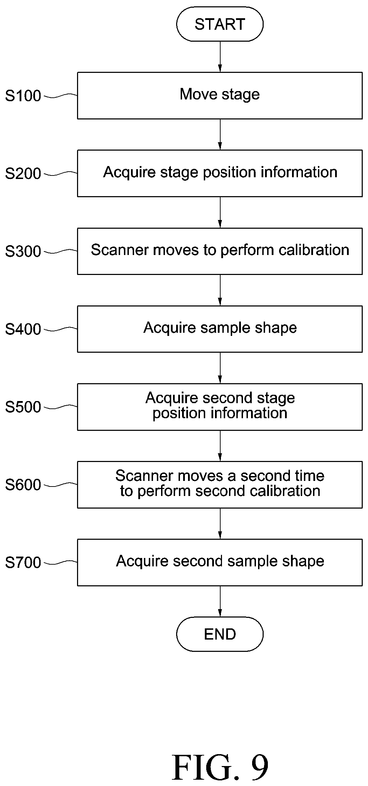

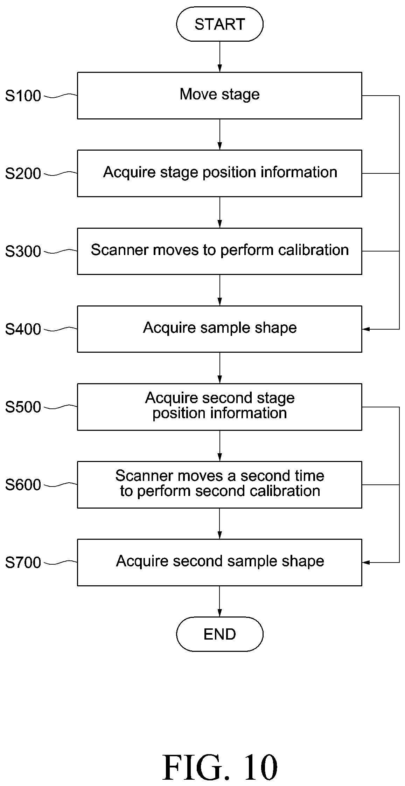

Referring to FIGS. 9 and 10, the stage calibration method further includes, after step S400: a second stage position information acquiring step (S500) in which the first measuring device 1300, 2300, or 3300 rescans and/or recaptures the reference sample 1101, 2101, or 3101 disposed on the stage 1100, 2100, or 3100 to acquire position information of the stage 1100, 2100, or 3100; a second calibration step (S600) in which the scanner 1200, 2200, or 3200 moves a second time based on the position information of the stage 1100, 2100, or 3100 acquired by the first measuring device 1300, 2300, or 3300 rescanning and/or recapturing the reference sample 1101, 2101, or 3101 such that the target sample 10 disposed on the scanner 1200, 2200, or 3200 is positioned at the target position; and a second sample shape acquiring step (S700) in which the second measuring device 1400, 2400, or 3400 rescans and/or recaptures the target sample 10 positioned at the target position.

Since the detailed description of the operation of each component in each step is as described above, only the features of the stage calibration method according to the present disclosure will be briefly described.

Referring to FIG. 7, in step S100, the stage 1100, 2100, or 3100 moves on the XY plane by driving of a moving device of the stage 1100, 2100, or 3100. In step S100, the stage 1100, 2100, or 3100 moves such that the target sample 10 disposed on the scanner 1200, 2200, or 3200 is positioned at the target position.

In step S200, the first measuring device 1300, 2300, or 3300 captures the plurality of markers 1103, 2103, and 3103 disposed on at least one surface of the reference sample 1101, 2101, or 3101 disposed on the stage 1100, 2100, or 3100 to generate a first vision image. The computation device analyzes the first vision image generated by the first measuring device 1300, 2300, or 3300, and acquires position information of the stage 1100, 2100, or 3100 through the marker 1103, 2103, or 3103 included in the first vision image.

In step S300, the scanner 1200, 2200, or 3200 moves on the XY plane by the scanner moving device. The movement of the scanner 1200, 2200, or 3200 can be finer than the movement of the stage 1100, 2100, or 3100. Therefore, the movement of the scanner 1200, 2200, or 3200 in step S300 can position the target sample 10 at the target position more accurately than the movement of the stage 1100, 2100, or 3100 in step S100.

In step S400, the second measuring device 1400, 2400, or 3400 captures the target sample 10 positioned at the target position to generate a second vision image including surface information of the target sample 10, and the computation device analyzes the second vision image to acquire a surface shape, a step, and the like of the target sample 10.

Referring to FIG. 8, step S400 may be performed together with step S100, step S200, and step S300, or after each step S100, S200, and S300, respectively. That is, the unit process on the target sample 10 in step S400 may be performed together with the calibration of the target sample 10 by the first measuring device 1300, 2300, or 3300. In addition, step S500 may be performed together with the unit process on each target sample 10 in step S400.

Referring to FIG. 9, in step S500, the first measuring device 1300, 2300, or 3300 continuously captures the reference sample 1101, 2101, or 3101 disposed on the stage 1100, 2100, or 3100 while the unit process on the target sample 10 is performed, to reacquire position information such as a positional variation of the stage 1100, 2100, or 3100. If a positional variation occurs in the stage 1100, 2100, or 3100 in step S500, step S600 is performed together with step S400.

In step S600, according to position information such as a positional variation of the stage 1100, 2100, or 3100 acquired by the first measuring device 1300, 2300, or 3300 recapturing the reference sample 1101, 2101, or 3101, the scanner 1200, 2200, or 3200 moves a second time again, so that the target sample 10 disposed on the scanner 1200, 2200, or 3200 is repositioned at the target position.

In step S700, the unit process on the target sample 10 positioned at the target position is performed by the second measuring device 1400, 2400, or 3400.

Referring to FIG. 10, step S700 may be performed together with step S500 and step S600, or after each step S500 and S600, respectively. Therefore, the acquisition of the position information of the stage 1100, 2100, or 3100 by the first measuring device 1300, 2300, or 3300 and the calibration of the scanner 1200, 2200, or 3200 can be performed together with the performing of the unit process by the second measuring device 1400, 2400, or 3400, so that there is a feature that the target sample 10 can be positioned at the target position without interruption of the unit process.

In this specification, a camera, a sensor, an optical microscope, or the like capable of capturing a surface of the reference sample 1101, 2101, or 3101 may be applied as the first measuring device 1300, 2300, or 3300 and the second measuring device 1400, 2400, or 3400. However, the present disclosure is not limited thereto, and an electron microscope or a scanning probe microscope may be applied as the first measuring device 1300, 2300, or 3300 and the second measuring device 1400, 2400, or 3400. For example, a cantilever and a probe of an atomic force microscope (AFM) may be applied, or an electron gun, a condenser lens, an objective lens, a scanning coil, and the like of a scanning electron microscope (SEM) may be applied, as the first measuring device 1300, 2300, or 3300 and the second measuring device 1400, 2400, or 3400.

In this specification, the computation device and the control device may be processors that execute consecutive processes stored in a memory. Alternatively, they may operate as software modules driven and controlled by a processor. Furthermore, the processor may be a hardware device.

The scope of protection of the present disclosure is not limited to the description and expressions of the embodiments explicitly described above. In addition, it is added once again that the scope of protection of the present disclosure cannot be limited by obvious changes or substitutions in the technical field to which the present disclosure belongs.

## Claims

1. A stage calibration device, comprising:
a stage on which a reference sample is disposed;
a scanner disposed above the stage, on which a target sample is disposed;
a first measuring device that scans the reference sample to generate a first vision image including position information of the stage;
a second measuring device that scans the target sample to generate a second vision image including surface information of the target sample; and
a control device that controls movement of the scanner,
wherein the control device moves the scanner according to a positional variation of the stage calculated based on the position information of the stage, so as to position the target sample at a target position.

2. The stage calibration device of Claim 1, wherein the first measuring device, when the second measuring device scans the target sample, scans the reference sample to acquire the position information of the stage, and the control device, when the second measuring device scans the target sample, moves the scanner to position the target sample at the target position together with acquisition of the surface information of the target sample.

3. The stage calibration device of Claim 1, wherein the stage is provided to be movable in an X-axis direction and a Y-axis direction on an XY plane, the reference sample and the target sample move together with the stage by the same displacement as the movement of the stage, the scanner is provided to be movable in the X-axis direction and the Y-axis direction on the XY plane, above the stage, independently of the movement of the stage, and the target sample moves together with the scanner by the same displacement as the movement of the scanner.

4. The stage calibration device of Claim 3, wherein the control device performs a second moving process of controlling the movement of the scanner to position the target sample at the target position, after performing a first moving process of controlling the movement of the stage to position the target sample at the target position.

5. The stage calibration device of Claim 4, further comprising:
a stage moving device that moves the stage; and
a scanner moving device that moves the scanner,
wherein a displacement of the scanner moved by the scanner moving device is relatively smaller than a displacement of the stage moved by the stage moving device.

6. The stage calibration device of Claim 1, wherein at least one marker is provided at a specific position on the reference sample, the first measuring device scans the marker to generate the first vision image including the position information of the stage, and the second measuring device scans an upper surface of the target sample to generate the second vision image including the surface information of the target sample.

7. The stage calibration device of Claim 6, wherein the stage comprises:
an upper frame on which the scanner is disposed;
a fixed frame having a hollow into which the first measuring device is inserted; and
a connecting frame connecting the upper frame and the fixed frame and providing a space in which the first measuring device scans the reference sample,
wherein the target sample is disposed on the scanner, and the reference sample is disposed under the upper frame.

8. The stage calibration device of Claim 7, wherein the reference sample includes the marker on a lower surface facing the hollow, and the first measuring device is inserted, through the hollow of the fixed frame, toward the space between the upper frame and the fixed frame provided by the connecting frame, and scans the marker included on the lower surface of the reference sample from below the reference sample.

9. The stage calibration device of Claim 8, wherein the reference sample is embedded in the upper frame and fixedly disposed.

10. The stage calibration device of Claim 6, wherein the stage comprises:
an upper frame on which the scanner is disposed;
a lower frame on which the reference sample is disposed; and
a connecting frame connecting the upper frame and the lower frame such that at least one side of the stage is open, and providing a space in which the first measuring device scans the reference sample,
wherein the target sample is disposed on the scanner.

11. The stage calibration device of Claim 10, wherein the reference sample includes the marker on an upper surface facing the upper frame, and the first measuring device is inserted, through the open side of the stage, into the space between the upper frame and the lower frame provided by the connecting frame, and scans the marker included on the upper surface of the reference sample from above the reference sample.

12. The stage calibration device of Claim 11, wherein the reference sample is embedded in the lower frame and fixedly disposed.

13. A stage calibration device, comprising:
a stage;
a scanner disposed above the stage, on which a reference sample and a target sample are disposed;
a first measuring device that scans the reference sample to generate a first vision image including position information of the stage;
a second measuring device that scans the target sample to generate a second vision image including surface information of the target sample; and
a control device that controls movement of the scanner,
wherein the control device moves the scanner according to a positional variation of the stage calculated based on the position information of the stage, so as to position the target sample at a target position.

14. A stage calibration method, comprising:
a stage moving step of moving a stage such that a target sample is positioned at a target position; a stage position information acquiring step of scanning, by a first measuring device, a reference sample disposed on the stage to acquire position information of the stage;
a calibration step of moving a scanner provided to be movable above the stage, based on the position information of the stage, such that the target sample disposed on the scanner is positioned at the target position; and
a sample shape acquiring step of scanning, by a second measuring device, the target sample positioned at the target position.

15. The stage calibration method of Claim 14, further comprising, after the sample shape acquiring step of scanning, by the second measuring device, the target sample positioned at the target position:
a second stage position information acquiring step of rescanning, by the first measuring device, the reference sample disposed on the stage to acquire the position information of the stage;
a second calibration step of moving the scanner a second time, based on the position information of the stage acquired by the first measuring device rescanning the reference sample, such that the target sample disposed on the scanner is positioned at the target position; and
a second sample shape acquiring step of rescanning, by the second measuring device, the target sample positioned at the target position.
